Europäisches Patentamt

European Patent Office

Office européen des brevets

(11) Publication number: **0 261 707**
**A1**

# (12) EUROPEAN PATENT APPLICATION

(21) Application number: 87201595.3

(22) Date of filing: 21.08.87

(51) Int. Cl.4: **G01R 19/20 , G01R 15/02**

(30) Priority: 22.08.86 NL 8602145

(43) Date of publication of application:
**30.03.88 Bulletin 88/13**

(84) Designated Contracting States:
**DE GB IT NL**

(71) Applicant: **HOLEC SYSTEMEN EN COMPONENTEN B.V.
Tuindorpstraat 61 P.O. Box 23
NL-7550 AA Hengelo(NL)**

(72) Inventor: **Groenenboom,Maarten
M. Samuelstraat 11
NL-7468 BN Enter(NL)**
Inventor: **Van de Water, Antonius Johannes
Anijsstraat 3
NL-7641 EB Wierden(NL)**

(74) Representative: **van der Beek, George Frans et al
Nederlandsch Octrooibureau Johan de Wittlaan 15 P.O. Box 29720
NL-2502 LS 's-Gravenhage(NL)**

(54) **Measuring circuit for continuous, accurate measurement of direct and alternating current.**

(57) The present invention relates to a measuring circuit for continuous and accurate measurement of direct and alternating currents, comprising a magnetic integrator having a transformer (T1), and an amplifier circuit (A), a magnetic modulator including two identical transformers (T2, T3), and an energizing circuit (OSC), and a peak detector (PD), connected as shown. The magnetomotive force generated by the current ($i_1$) to be measured is compensated by a secondary current ($i_2$) from the amplifier circuit (A), in such a way that the mean flux in the transformers (T1, T2, T3) becomes zero. The output circuit of the amplifier circuit (A) is provided with a non-linear resistance (not shown), through which the secondary current ($i_2$) is flowing for compensation of a current ($i_1$) in excess of the rated current of the amplifier circuit (A), such that during an excess current interval the measuring circuit operates as a conventional current transformer. For restoring the zero-flux operation after the primary excess current is removed, a circuit consisting of a saturation detector (VD) and a buffer or calibration amplifier circuit (B) is provided.

fig-4

Measuring circuit for continuous, accurate measurement of direct and alternating current.

The present invention relates to a measuring circuit for continuous and accurate measurement of direct and alternating currents, comprising a transformer with a primary winding passed through by the current to be measured, a control winding, and a secondary winding, which are accommodated in the input and output circuit respectively of an amplifier circuit, and which are connected in such a way that the flux change caused by a current variation in the primary winding is virtually eliminated by a proportionate current variation in the secondary winding, a correction circuit which works in concert with the amplifier circuit in such a way that the residual flux caused by a primary direct current is virtually eliminated by a proportionate direct current in the secondary winding, and by means of which the mean value of the flux is maintained virtually at zero under drift phenomena, and a load passed through by the secondary current, while during the occurrence of a primary excess current the transformer functions as an ordinary current transformer for alternating current during the excess current interval.

Such a circuit is described in the article "Zero-Flux Current Transformer for Wide-Band Precision Measurement in AC and DC HV systems, Proceedings IEE Fourth International Conference on AC and DC HV Power Transmission, London, 23-26 Sept. 1985".

The magnetomotive force generated by the current in the primary winding of a transformer is compensated for herein by a current coming from the amplifier circuit, in such a way that the resulting field in the transformer core becomes zero.

Use is made here of an amplifier circuit which acts as a magnetic integrator and a magnetic modulator as correction circuit for maintaining the working point (flux = zero) of the integrator. In addition to a number of important advantages, in particular a very accurate current measurement, this known circuit has the following limitations:

For the measurement of excess currents the amplifier would have to be designed for the highest peak value which could be expected for the excess current, which is expensive and consequently allows use only if the quality of the measurement takes precedence over economic requirements, for example in the scientific field:

If the primary current is already flowing before the circuit is operational, so that the magnetic material is saturated, no signal can be derived for finding the working point of the integrator; due to the necessary short voltage interruption, the circuit is less suitable for, for example, transmission or distribution applications.

The object of the invention is to eliminate these limitations and make the circuit suitable for wider applications. The circuit according to the invention is thereto characterized in that connected over the output of the amplifier circuit is a non-linear resistor, through which when a particular limit voltage is exceeded the current will increase sharply if the output current of the amplifier circuit is limited.

The amplifier can now be dimensioned for an output current which corresponds to the rated value of the primary current, and the transformer will act as a conventional current transformer during the excess current interval. The secondary current is here generated by the voltage induced in the secondary winding.

In a preferred embodiment of the invention, the non-linear resistor consists of two Zener diodes which are connected back-to-back-in series. Advantageously, the non-linear resistor can also consist of at least one switch which bridges the output of the amplifier circuit when the rated value of the secondary current is exceeded.

Another preferred embodiment according to the present invention is characterized in that by means of the at least one switch the output of the amplifier circuit is alternately bridged via a positive and a negative voltage source during the intervals which correspond to the intervals at which the secondary current has a positive or a negative direction, so that the voltage-time area of the voltage induced in the secondary winding is minimal

Yet another embodiment according to the present invention is characterized in that the non-linear resistor is connected parallel to the series circuit of the secondary winding and the load.

According to yet a further embodiment of the invention, the non-linear resistor connected in this way can also consist of a first and a second series circuit of a switch and a supply source, these two series circuits being connected in parallel to a series circuit of the secondary winding and the load, and in which -depending on the direction of the secondary excess current - either the switch and the supply source of the first or the switch and the supply source of the second series circuit are operational, the selection of the switch and the supply source of the two series circuits being such that the voltage-time area of the voltage induced in the secondary winding is minimal.

Since, however, during the occurrence of a primary excess current the measuring circuit according to the present invention operates as an ordinary current transformer, saturation can take place during an excess current situation, inter alia, due to a primary direct current or a direct current component in the primary alternating current. In order to restore the zero-flux situation again when the primary current returns to within the rated value, in yet another preferred embodiment the measuring circuit according to the invention is provided with a detection circuit by means of which the saturation state of the cores can be indicated, in such a way that during the saturation state a relaxation-oscillator circuit is closed, so that the output current of the amplifier circuit traverses its entire working range once the primary excess current is removed. Here, that value at which the magnetomotive force generated by the primary winding is compensated for by the magnetomotive force generated by the secondary winding will also be reached. The correction circuit, which will in consequence start functioning in its working range, produces a signal which fixes the working point of the integrator and puts the relaxation-oscillator circuit out of action.

Yet another preferred embodiment according to the invention is characterized in that the correction circuit has a saturation detector, a switch, and a second amplifier circuit, the second amplifier circuit being controlled by the voltage across the load, and the saturation detector, after a detected saturation of the transformer core, shutting off the switch, as a result of which a relaxation-oscillator is created, consisting of an amplifier circuit, the secondary winding, the second amplifier circuit, and the switch, and in which as soon as the primary excess current is removed the relaxation-oscillator controls the amplifier circuit in such a way that there is complete compensation for the primary current causing saturation of the transformer core.

The main advantage of the measuring circuit according to the present invention is that accurate current measurement over an extremely large measuring range is possible. Up to the rated value of the direct or alternating current, the measuring is according to the zero-flux principle, resulting in high accuracy. Above the rated value, measurement takes place with the usual accuracy according to a conventional current transformer for alternating current, the magnetizing current of which is very small relative to the excess current to be measured. A second advantage is that the detection circuit ensures that, when the excess current disappears, the current measurement is quickly restored according to the zero-flux principle.

The invention will now be explained in greater detail below with reference to the appropriate figures.

Fig. 1 shows the circuit diagram of the magnetic integrator known from the above-mentioned publication.

Fig. 2 gives an example of an embodiment of the combination of a magnetic integrator with a correction circuit for fixing the working point, also as disclosed in the said publication.

Fig. 3 serves to illustrate one of the known methods on which the working of the correction circuit is based.

Figs. 4, 5, 6 and 7 indicate schematically how according to the present invention the secondary excess current can be conveyed fully or partially bypassing the amplifier.

Fig. 8 shows a circuit by means of which through variation of the output current of the amplifier the value is scanned, so that a balance is achieved between the magnetomotive force generated in the primary and secondary windings.

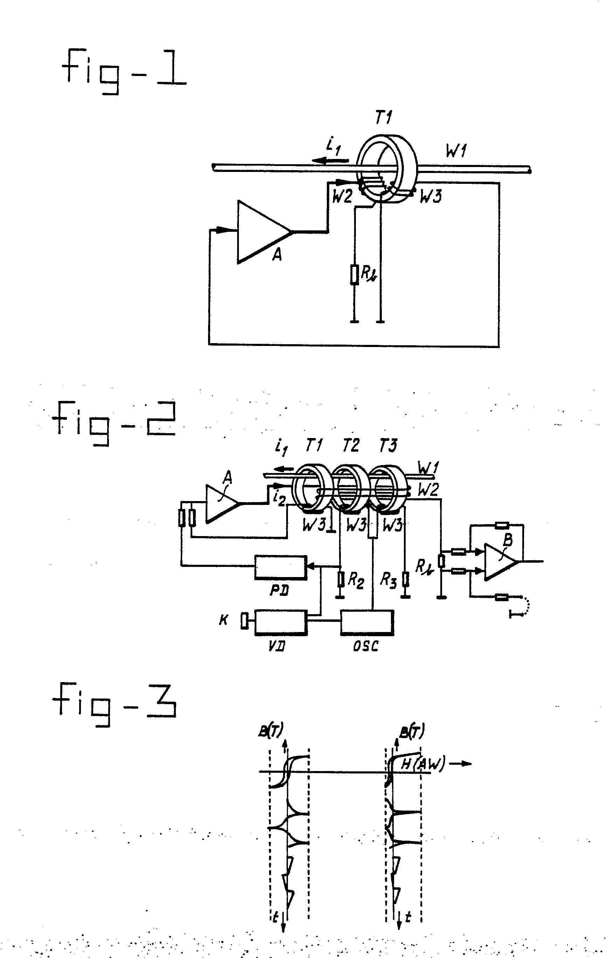

In Fig. 1, T1 is a toroidal core of a tranformer which is provided around a conductor which forms the primary winding W1 through which the current $i_1$ to be measured flows. The core is also provided with a secondary winding W2, which is accommated in the output circuit of the amplifier A, and a tertiary control winding W3 which is connected to the input of the amplifier A. The output circuit of A is closed by a load resistor Rb. The polarity of the magnetomotive force generated by the amplifier circuit in W2 is such that any change in the flux in the core under the influence of the voltage induced in W3 is counteracted by a change in the output current of the amplifier.

If we assume an ideal amplifier with a frequency-independent infinite amplification factor and no offset and drift, then no change in the magnetic flux in the core T1 is permitted. For a flux change in the core will result in an induced voltage in the winding W3, which as input signal affects the output current of the amplifier in such a way that the flux change is eliminated. The induced voltage ins W3, and consequently the magnetic flux in the core, must remain zero. The amplifier will therefore transmit such a current through the winding W2 that there is complete compensation for the magnetomotive force generated by W1. The current in the secondary circuit is thereby an accurate representation of that in the primary circuit, but w1/w2 times as large, w1 being the number of turns of winding W1, and w2 being the number of turns of winding W2.

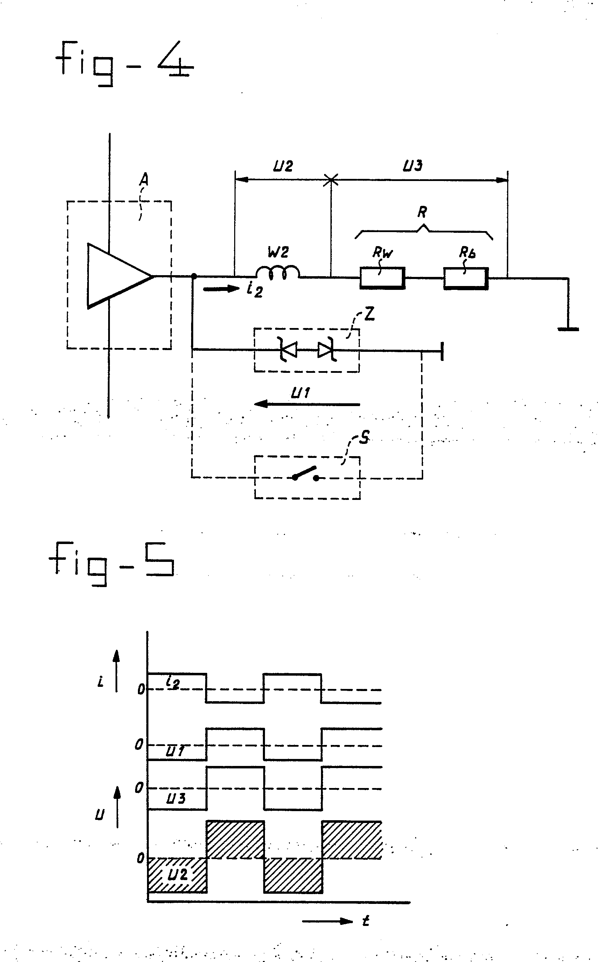

In reality, the amplification factor is finite and frequency-dependent, and there is offset and drift. As a result, a slight voltage will be induced in W3 for the flux compensation. The flux in the core will change slowly and creep towards saturation. On reaching the saturation point, the normal functioning of the circuit ends. In order to prevent this, a correction circuit is added (see Fig. 2), which has two wound cores T2 and T3 identical to T1.

The windings W1 and W2 now all have three cores. T2 and T3 together with the alternating voltage source OSC and the peak detector PD form part of a so-called magnetic modulator. The windings W3 of T2 and T3 are each connected to the alternating voltage source OSC by means of resistors R2 and R3 respectively. The source OSC results in such a magnetizing current that the two cores T2 and T3 are constantly driven in saturation.

The shape of this magnetizing current is shown in Fig. 3, the left half illustrating the situation without residual magnetic field, and the right half illustrating the situation with a means residual field deviating from zero in the cores. The first line of Fig. 3 shows the magnetizing flux, line 2 the magnetomotive force proportionate to the magnetizing current, which in the situation shown in the right half also exhibits a saturation peak, and line 3 shows the variation with time of the output signal of the peak detector PD.

If the average value of the magnetic field in the cores is zero, the magnetizing current will be symmetrical in shape, as shown in the left half of Fig. 3. The positive and negative peak values are identical. If the two values are substracted from each other after peak rectification, then the difference is zero. This is no longer the case if the mean value of the magnetic field is no longer zero, as shown in the right half of Fig. 3. The magnetizing current is asymmetrical in shape which results in a difference signal as output signal of the peak detector PD.

The polarity and size of this difference signal are a measure of the sign and the size of the residual magnetic field in the cores. If this signal is now fed together with the signal from winding W3 of T1 in the correct polarity to the amplifier A, it will produce such current that the residual field is kept extremely small. The size of this residual field is determined by the amplification factor of A.

It will be clear that by means of the magnetic modulator not only the offset and drift influences of the amplifier A can be compensated for, but also residual magnetic fields as a result of stationary or transient direct currents or direct current components in the current $i_1$ to be measured. The secondary current $i_2$ is therefore an accurate representation of the primary alternating or direct current or a combination of both.

In principle, one extra core, for example T2, could suffice in addition to T1. In order to avoid voltage being induced in the primary and secondary circuit as a result of the alternating voltage in W1 and W2 fed by the source OSC to W3 of T2, T3 is added with W3 and R3 and connected in such a way that the voltages induced by the source OSC via T2 in W1 and W2 are eliminated by an induction voltage in counterphase. The total induced voltage in the primary and secondary circuit is thereby virtually zero.

In order to avoid measuring errors as a result of the loading of resistor Rb, and in order to obtain a standardised measuring range, a buffer or cablibration amplifier circuit B is provided parallel to Rb, and has adjustable feedback. The amplifier circuits A and B are preferably symmetrical differential amplifiers, for example operational amplifiers whih can be fed from the mains supply to be monitored or by means of external voltage sources (not shown). The resistor Rb is preferably a precision resistor of high accuracy and stability.

If in consequence of the primary current the magnetomotive force is greater than the maximum compensating magnetomotive force generated by the output current of the amplifier circuit, the zero-flux state is disrupted. Due to the flux change and without additional means such voltage will then be induced in W2 that the necessary compensating current required for this is driven via the output circuit of the amplifier circuit A. This excess current could damage the amplifier circuit.

Fig. 4 shows a circuit according to the invention by means of which the excess current can be conveyed completely or partially bypassing the amplifier circuit. In this figure, R represents the sum of the load resistor Rb and the ohmic resistance Rw of the winding W2. Disposed across the output of the amplifier circuit A is a voltage-controlled non-linear resistor, for example a bipolar Zener diode circuit Z, comprising two Zener diodes connected back-to-back in series. Up to a particular limit value of the output current of the amplifier circuit only a slight, negligible current will flow through Z. If this limit is exceeded, then the current of the amplifier circuit will no longer increase and will be added to by the current through the Zener diode at such a value that there is compensation for the magnetomotive force caused by the primary excess current. The output voltage of the amplifier circuit A is virtually unable to increase and will be limited at a particular value $U_1$. Since W2 is now acting as a "supply source", $U_1$ will also change direction due to the higher voltages induced in W2 thus it will, as it were, "reverse". The Zener diode circuit 2 acts in this situation virtually as a short circuit. The amplifier acts in current limitation, or is taken to a blocked state during the excess current interval by a control circuit (not shown).

Fig. 5 shows the variation in the voltage $U_2$ across W2, $U_1$ across Z, and U3 across R, and the current $i_2$ through W2, assuming a primary excess current which varies in a rectangular fashion with time (where the core is not saturated). The rectangular form is assumed here for the sake of simplicity.

During the time thast a primary excess current is flowing the circuit shown in Fig. 2 works like an ordinary current transformer. Because the amplifier circuit A is blocked, and consequently the correcting action of the magnetic modulator, any residual magnetic field in T1 is no longer corrected.

The flux change in the cores is determined by the voltage-time area of $U_2$, in other words, the surface which is hatched in Fig. 5. If the excess current is a direct current or has a direct current component, saturation will occur after some time, which means that no further flux increase is possible, so that the induced voltages become zero and the secondary current is no longer a measure of the primary current.

This situation can be observed, by means of the saturation detector VD shown in Fig. 2 from the phase difference btween the voltage over R2 and the output voltage of the alternating voltage source OSC or the voltage over W3. In the case of an unsaturated core the current and the voltage of W3 are shifted in phase. This phase shift is virtually zero in the saturated state, because the current is now largely determined by the resistance in the circuit. By means of a switch K operated by the output signal of the saturation detector, this situation can be indicated by external signalling, and a switch-off command to a main switch in the primary circuit can, for example, be given via the control and/or protection system.

It will be cleasr that the active cross section of the core has to be selected in such a size that the required excess current can be measured during the required time.

The induced voltage over W2 can be reduced and thereby at a given active cross section the excess current and the measuring time increased by replacing Z in Fig. 4 by the switch S. This switch S is closed if the maximum current to be delivered by the amplifier circuit A is exceeded.

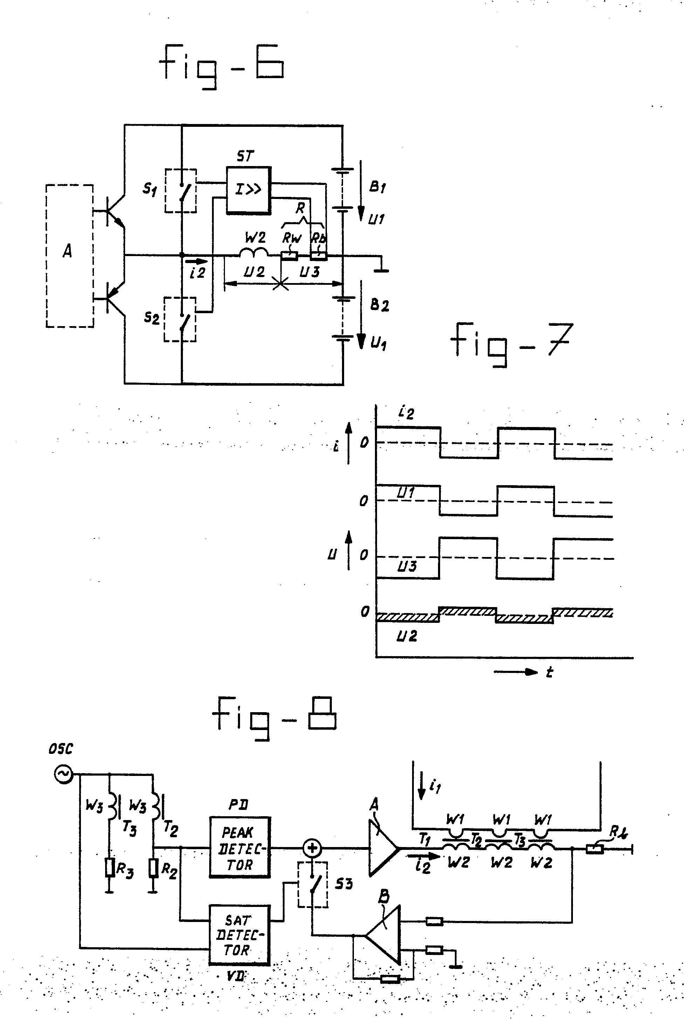

In Fig. 6 the voltage-controlled non-linear resistor Z is replaced by two switches S1 and S2. In normal operation S1 and S2 are opened. If the secondary current $i_2$ exceeds the maximum value to be supplied by the amplifier, then the control circuit ST of the switches, which is connected parallel to the load resistor Rb, becomes operative and closes a switch depending on the polarity of $i_2$. The control circuit can have a comparator in the usual way to measure the size and polarity of the voltage across Rb and compare it with a preset value. The control circuit preferably has sufficient hysteresis to produce a stable switching. The amplifier circuit functions during the closing intervals in current limitation or is brought to in the blocked state. Instead of two switches S1/S2, use can, of course, be made of one common two-way switch. The switches can be either mechanical or electronic components. Since the voltage $U_1$ itself can be reversed in the circuit of Fig. 6, using the voltage sources B1/B2, $U_2$ -in which saturation is brought about -will also be positively influenced, in other words, the saturation is delayed and thus measurements can take place for a longer time during excess current.

Fig. 7 shows the voltage curve in a similar way to that in Fig. 5. Part of the voltage $U_3$ is now supplied by the supply source B1, B2 respectively, so that $U_2$ -and thereby the voltage-time area thereof - is smaller here than in Fig. 5. The saturation of the magnetic core is hereby, as it were, "delayed".

During an excess current situation the magnetic integrator - and consequently the magnetic modulator -is out of action. When in consequence of the excess current the cores have reached a saturated state, the magnetic modular gives off no further correcting signal. For the magnetizing current in W3 of, say, T2 is now virtually solely determined by the resistor R2 and the alternating voltage source OSC, which means that it has a symmetrical shape, which is also the case in the zero-flux state. When the primary current comes within the measuring range again, because of the saturation state of the cores, the magnetic modulator cannot ensure that the working point of the magnetic integrator is recovered. A similar situation occurs also when the cores are already saturated before a primary current starts to flow.

In order to take the cores out of the saturation state and recover the working point, the magnetomotive force balance must be located. For this, the output current of the amplifier circuit of the magnetic integrator must traverse its entire working range, which is achieved through temporarily providing a positive feedback circuit.

Fig. 8 gives a block diagram of a circuit which can be used for this. The saturation state is again found from the phase change of the circuit relative to the voltage in the energizing circuit formed by OSC, W3 and R2 of the core T2 or the value of the voltage over W3, as shown in Fig. 2. Once the saturation state is detected, the saturation detector VD closes the mechanical or electronic switch S3. The output of the second amplifier circuit B, which is controlled by the voltage across Rb, is then connected to the input of the amplifier circuit A. Once the primary excess current is removed, the thus closed circuit forms in principle a ready-made relaxation-oscillator which makes the output current of the amplifier circuit A traverse its entire working range. In excess current situations the amplifier A is not, however, capable of processing the excess current, and the relaxation-oscillator will therefore not work. Once the current is again within the range of the amplifier, the relaxation-oscillator becomes active. The output current will thereby reach that value at which there is compensation for the magnetomotive force generated by the primary current. The cores consequently come out of the saturation state. The magnetic modulator can again give a correction signal, while through an action of the saturation detector the switch S3 is opened. The relaxation-oscillator consequently stops immediately. The correction signal coming from the magnetic modulator restores the normal working point of the magnetic integrator. For the sake of clarity, the excess current circuit according to the invention, for example as shown in Figs. 4 and 6, is not shown in this block diagram.

The measuring circuit according to the present invention has a relatively broad-band measuring range. which means that transient currents can also be measured accurately. The structure and design are such that external magnetic fields can have only a negligible influence.

It goes without saying that the invention is not limited to the embodiments discussed above and shown in the figures, but that modifications and additions can be provided, for example in the layout of the correction circuit, the mutual arrangement of the magnetic cores, or the use of other non-linear current-controlled or voltage-controlled elements for making the excess current bypass the amplifier A, without going beyond the scope of the invention.

## Claims

1. Measuring circuit for continuous and accurate measurement of direct and alternating currents, comprising a transformer with a primary winding passed through by the current to be measured, a control winding, and a secondary winding, which are accommodated in the input and output circuit respectively of an amplifier circuit, and which are connected in such a way that the flux change caused by a current variation in the primary winding is virtually eliminated by a proportionate current variation in the secondary winding, a correction circuit which works in concert with the amplifier circuit in such a way that the residual flux caused by a primary direct current is virtually eliminated by a proportionate direct current in the secondary winding, and by means of which the mean value of the flux is maintained virtually at zero under drift phenomena, and a load passed through by the secondary current, while during the occurence of a primary excess current the transformer functions as an ordinary current transformer for alternating current during the excess current interval, characterized in that connected over the output of the amplifier circuit is a non-linear resistor, through which when a particular limit voltage is exceeded the current will increase sharply if the output current of the amplifier circuit is limited.

2. Measuring circuit according to Claim 1, characterized in that the non-linear resistor consists of two Zener diodes connected back-to-back in series.

3. Measuring circuit according to Claim 1 or 2, characterized in that the non-linear resistor consists of at least one switch which bridges the output of the amplifier circuit when the rated value of the secondary current is exceeded.

4. Measuring circuit according to Claim 3, characterized in that by means of the at least one switch the output of the amplifier circuit is alternately bridged via a positive and a negative voltage source during the intervals which correspond to the intervals at which the secondary current has a positive or a negative direction, so that the voltage-time area of the voltage induced in the secondary winding is minimal.

5. Measuring circuit according to Claims 1 to 4, characterized in that the non-linear resistor (Z) is connected parallel to the series circuit of the secondary winding (W2) and the load (Rb).

6. Measuring circuit according to Claim 5, characterized in that the non-linear resistor consists of a first and a second series circuit of a switch (S1/S2) and a supply source (B1/B2), these two series circuits being connected in parallel to a series circuit of the secondary winding (W2) and the load (Rb), and in which -depending on the direction of the secondary excess current - either the switch (S1) and the supply source (B1) of the first or the switch (S2) and the supply source (B2) of the second series circuit are operational, the selection of the switch (S1/S2) and the supply source (B1/B2) of the two series circuits being such that the voltage-time area of the voltage induced in the secondary winding is minimal.

7. Measuring a circuit according to Claims 1 to 6, provided with a detection circuit by means of which the saturation state of the cores can be indicated, characterized in that during the saturation state a relaxation-oscillator circuit is closed, so that the output current of the amplifier circuit traverses its entire working range once the primary excess current is removed.

8. Measuring circuit according to Claim 7, characterized in that the correction circuit has a saturation detector (VD), a switch (S3), and a second amplifier circuit (B), the second amplifier circuit (B) being controlled by the voltage across the load (Rb), and the saturation detector (VD), after a detected saturation of the transformer core, closes the switch (S3), as a result of which a relaxation-oscillator is created, consisting of the amplifier circuit (A), the secondary winding (W2), the second amplifier circuit (B), and the switch (S3), and in which as soon as the primary excess current is removed the relaxation-oscillator controls the amplifier (A) in such a way that there is complete compensation for the primary current causing saturation of the transformer core.

fig-1

fig-2

fig-3

# fig-4

# fig-5

# Fig-6

# Fig-7

# Fig-8

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| A | ELEKTROTECHNISCHE ZEITSCHRIFT, vol. 100, n0. 24, November 1979, pages 1390-1394, Berlin, DE; J. LISSER et al.: "Nulfluss-Stromwandler zur Messung von Gleich- und Wechselströmen" * Page 1390, column 1, line 1 - page 1391, column 3, line 25; figures 1-4 * | 1,7 | G 01 R 19/20 G 01 R 15/02 |
| A | MESUCORD '63 "CONGRES INTERNATIONAL: MENU-CONTROLE-REGULATION-AUTOMATISME", 1963, pages 244-249, Paris, FR; R.C. MARSHALL et al.: "A direct current transformer" * Page 244, lines 13-25; page 246, lines 21-31; page 248, lines 21-41; figures 2-5 * | 1,2,5 | |
| A | US-A-4 298 838 (AKAMATSU) * Column 3, line 28 - column 5, line 10; figure 3 * | 3-6 | |
| A | DE-A-2 730 874 (HAZEMEIJER B.V.) * Page 13, line 19 - page 15, line 9; figure 1 * | 3,4 | TECHNICAL FIELDS SEARCHED (Int. Cl.4) |
| P,A | WO-A-8 605 888 (R. BOSCH GmbH) * Page 5, lines 6-17; figure 1 * | 2,5 | G 01 R 19/00 G 01 R 17/00 G 01 R 15/00 H 01 F 40/00 |

The present search report has been drawn up for all claims

| Place of search | Date of completion of the search | Examiner |
|---|---|---|
| THE HAGUE | 10-12-1987 | TRELEVEN C. |